Europäisches Patentamt

European Patent Office

Office européen des brevets

(19)

(11) Veröffentlichungsnummer : **0 089 382**
**B1**

(12) **EUROPÄISCHE PATENTSCHRIFT**

(45) Veröffentlichungstag der Patentschrift :
20.08.86

(21) Anmeldenummer : 82102224.1

(22) Anmeldetag : 18.03.82

(51) Int. Cl.⁴ : **C 23 C 16/50,** C 23 C 14/40,
C 23 F 4/00, H 01 J 37/32//
H01L21/302

(54) Plasmareaktor und seine Anwendung beim Ätzen und Beschichten von Substraten.

(43) Veröffentlichungstag der Anmeldung :
28.09.83 Patentblatt 83/39

(45) Bekanntmachung des Hinweises auf die Patenterteilung : 20.08.86 Patentblatt 86/34

(84) Benannte Vertragsstaaten :
DE FR GB IT

(56) Entgegenhaltungen :
DD-A- 135 091
DD-A- 142 568
DE-A- 2 702 165
DE-A- 2 930 391
DE-A- 2 943 862
DE-A- 3 030 814
US-A- 3 757 733

(73) Patentinhaber : IBM DEUTSCHLAND GMBH
Pascalstrasse 100
D-7000 Stuttgart 80 (DE)
DE
International Business Machines Corporation
Old Orchard Road
Armonk, N.Y. 10504 (US)
FR GB IT

(72) Erfinder : Hinkel, Holger, Dr. Dipl.-Phys.
Zeisigweg 13
D-7030 Böblingen (DE)
Erfinder : Kaus, Gerhard, Dr. Dipl.-Min.
Talstrasse 56
D-7031 Mötzingen (DE)
Erfinder : Kraus, Georg
Im Heinental 70
D-7277 Wildberg 4 (DE)
Erfinder : KUENZEL, ULRICH, Dr. Dipl.-Chem.
August-Lämmle-Strasse 8
D-7408 Kusterdingen (DE)
Erfinder : Mühl, Reinhold
Würmstrasse 43
D-7031 Altdorf (DE)

(74) Vertreter : Oechssler, Dietrich, Dr. rer. nat.
Schönaicher Strasse 220
D-7030 Böblingen (DE)

EP 0 089 382 B1

## 0 089 382

**Beschreibung**

Die Erfindung betrifft einen Plasmareaktor zum Ätzen und Beschichten von Substraten mittels in einer Gasentladung angeregter Gaspartikel, welcher in einer Reaktionskammer zwei zueinander parallele, übereinander angeordnete plattenförmige Elektroden aufweist, wobei die obere der Elektroden an einer hochfrequenten Wechselspannung liegt, auf der unteren der Elektroden die Substrate liegen und diese Elektrode außerdem in der Mitte eine Öffnung aufweist, durch welche das reaktive Gas entweder in den Raum zwischen den Elektroden geleitet oder aus ihm abgesaugt wird, und ein Verfahren zum Ätzen und Beschichten von Substraten unter Anwendung eines solchen Plasmareaktors.

Plasmareaktoren der genannten Art sind beispielsweise in der DE-A-27 02 165 und in der US-A-3 757 733 beschrieben. Die in den genannten Schriften beschriebenen Plasmareaktoren werden zum Erzeugen von Schichten eingesetzt, jedoch können dieselben Reaktoren, wenn die Verfahrensbedingungen entsprechend gewählt werden, auch zum Plasmaätzen verwendet werden. Ein Aufsatz von A. R. Reinberg, der das Plasmaabscheiden von Schichten betrifft, ist in der Zeitschrift Ann. Rev. Mater. Sci., 1979, 9, Seite 341 ff. unter dem Titel « Plasmadeposition of Inorganic Thin Films » veröffentlicht. Vom selben Autor ist in den Extended Abstracts, Vol. 76-1 zum Electrochemical Society Spring Meeting, Mai 1976, Abstract Nr. 50, ein Übersichtsartikel, das Plasmaätzen betreffend, mit dem Titel « Plasmaetching in Semiconductor Manufacture - A Review » veröffentlicht worden.

Das Plasmaätzen und das Plasmaabscheiden sind Verfahren, welche sich dadurch auszeichnen, daß bei ihnen — anders als bei den naßchemischen Verfahren — Verunreinigungen der zu bearbeitenden Substrate während der Bearbeitung vernachlässigbar gering ist, und daß sie beim gegenwärtigen Stand der Technik sehr kontrolliert durchgeführt werden können und deshalb innerhalb enger Toleranzen gut kontrollierte Ergebnisse liefern. So ist es möglich, beim Plasmaätzen über die einzelnen Substrate und die ganze auf der unteren Elektrode des Plasmareaktors aufliegende gleichzeitig prozessierte Charge von Substraten innerhalb etwa ± 3% eine einheitliche Ätztiefe zu erhalten. Ähnliches läßt sich für die Plasmaabscheidung sagen, bei der es möglich ist, über dem ganzen Bereich der unteren Elektrode innerhalb von etwa ± 5 % eine einheitliche Dicke der aufgebrachten Schicht zu erreichen. Es kommt beim Plasmaabscheiden hinzu, daß die Eigenschaften der aufgebrachten Schichten, beispielsweise ihr Brechungsindex und ihre Ätzgeschwindigkeit, mit den Eigenschaften solcher Schichten vergleichbar sind, welche mit den bekannten konventionellen Methoden erzeugt worden sind. Ein Nachteil der Plasmaverfahren, welcher insbesondere bei ihrer Anwendung in einer Fabrikation ins Gewicht fällt, ist die geringe Geschwindigkeit, mit der mit ihnen Substrate geätzt bzw. auf ihnen Schichten aufgewachsen werden können, wenn die oben angeführten Toleranzbereiche eingehalten werden müssen.

Es ist die Aufgabe der Erfindung, einen Plasmareaktor und ein mit diesem Reaktor durchführbares Verfahren zum Ätzen und Abscheiden von Material mit einer im Vergleich zum Stand der Technik höheren Geschwindigkeit bei unverändert guter Gleichförmigkeit des Ätzens und des Abscheidens und unverändert guten Eigenschaften der aufgebrachten Schichten anzugeben.

Diese Aufgabe wird mit einem Plasmareaktor der eingangs genannten Art mit den Merkmalen des kennzeichnenden Teils des Anspruchs 1 und mit einem Verfahren der eingangs genannten Art mit dem Merkmal des kennzeichnenden Teils des Anspruchs 7 gelöst.

Beim Abscheiden von Material mittels eines Plasmas gibt es zwei konkurrierende Effekte, die letztlich die Abscheidungsgeschwindigkeit bestimmen : einerseits wird Material, das sich aus den reaktiven Gasen bildet, auf den Substraten abgeschieden, andererseits wirken jedoch die auf dem Substrat auftreffenden Teilchen aufgrund der kinetischen Energie auch materialabtragend.

Bei dem genannten Verfahren gemäß dem Stand der Technik ist es zwar bekannt, die Abscheidgeschwindigkeit zu erhöhen, indem die Prozeßparameter verändert werden. Nachteilig dabei ist, daß dabei zum Teil drastische Änderungen in den physikalisch chemischen Eigenschaften der abgeschiedenen Filme sowie eine Inhomogenität der Abscheidung hingenommen werden müssen. Überraschenderweise ist es mit einem Plasmareaktor mit der erfindungsgemäßen Ausbildung möglich, Filme mit einer höheren Geschwindigkeit als ohne diese Ausbildung abzuscheiden, ohne daß dabei die Prozeßparameter geändert werden müssen. Da die Prozeßparameter unverändert sind, haben auch die abgeschiedenen Filme dieselben Eigenschaften, beispielsweise denselben Brechungsindex und dieselbe Ätzgeschwindigkeit, wie solche Filme, welche mit Plasmareaktoren konventioneller Bauart abgeschieden worden sind. Die Erklärung für den beobachteten Effekt dürfte auf eine Störung und Schwächung des elektrischen Feldes unterhalb der Bereiche der oberen Elektrode, die kein Elektrodenmaterial aufweisen, zurückzuführen sein. Da die materialabtragende Wirkung der Partikel, welche auf die Substrate auftreffen, wegen des schwächeren elektrischen Feldes unterhalb der genannten Bereiche schwächer ist, können die geschwindigkeitsbestimmenden Oberflächenreaktionen begünstigt ablaufen. Dies führt zu der beobachteten, im Vergleich zu den mit den bekannten Plasmareaktoren erzielten höheren Abscheidungsgeschwindigkeit.

Die Abscheidung in Plasmareaktoren ist nicht auf die Substrate beschränkt, sondern erfolgt auf die gesamte untere Elektrode. Werden die Bereiche in der oberen Elektrode, welche kein Elektrodenmaterial aufweisen, ihrer Lage und Ausbildung nach auf die Substrate auf der unteren Elektrode abgestimmt, so läßt sich erreichen, daß die Abscheidung mit erhöhter Geschwindigkeit nur auf den Substraten erfolgt.

2

Dies hat den weiteren Vorteil, daß ein Planarreaktor länger zum Abscheiden benutzt werden kann, bevor es notwendig ist, die untere Elektrode zwecks Reinigung abzuätzen.

Beim Plasmaätzen unter Verwendung konventioneller Plasmareaktoren werden die ätzaktiven Spezies im gesamten Elektrodenraum gebildet. Viele der ätzaktiven Spezies werden deshalb ohne daß sie ihre Ätzwirkung entfalten können vom Gasstrom weggeführt. Bei dem erfindungsgemäßen Plasmareaktor bewirkt — wie bereits oben ausgeführt worden ist — die spezielle Ausbildung der oberen Elektrode bereichsweise eine Störung des elektrischen Feldes im Elektrodenraum. Es ist nun offenbar so, daß dort, wo das elektrische Feld gestört ist, eine bevorzugte Bildung von ätzaktiven Spezies stattfindet. Werden nun die Substrate 3 zu den Gebieten mit gestörtem elektrischen Feld in der geeigneten Weise ausgerichtet plaziert, so sind sie einer höheren Konzentration der ätzaktiven Spezies ausgesetzt und werden deshalb mit größerer Geschwindigkeit geätzt als dies in den bekannten Plasmareaktoren der Fall ist.

Vorteilhafte Ausgestaltungen des erfindungsgemäßen Plasmareaktors und des erfindungsgemäßen Verfahrens, auf welche in der Beschreibung noch im einzelnen eingegangen wird, sind in den Unteransprüchen definiert.

Die Erfindung wird anhand von durch Zeichnungen erläuterten Ausführungsbeispielen beschrieben. Es zeigen :

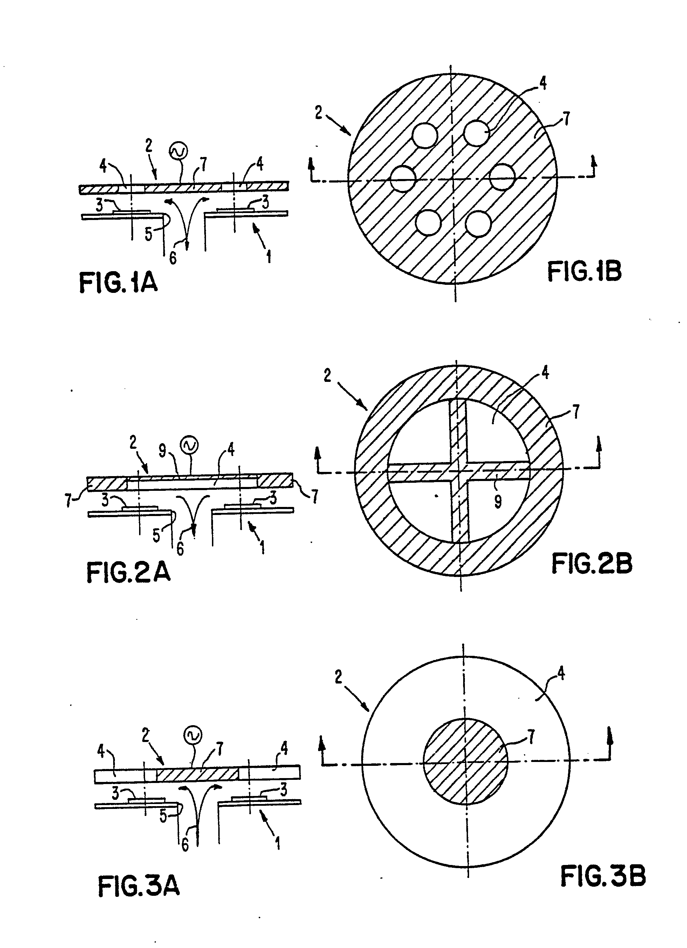

Figuren 1A bis 3B schematische Darstellungen jeweils im Querschnitt und in Aufsicht von drei Ausführungsformen des Elektrodenraumes des erfindungsgemäßen Plasmareaktors.

Der erfindungsgemäße Plasmareaktor mit zwei plattenförmigen, zueinander parallelen und übereinanderliegenden Elektroden unterscheidet sich durch die Ausbildung der oberen Elektroden von bekannten Plasmareaktoren.

Ein bekannter Plasmareaktor, wie er beispielsweise in dem US-Patent 3 757 733 beschrieben ist, weist in einer Reaktionskammer zwei plattenförmige, beispielsweise runde, parallel zueinander angeordnete und übereinanderliegende Elektroden auf. Der Reaktionsraum hat mindestens einen Gaseinlaß und einen mit einer Vakuumpumpe verbundenen Gasauslaß. Die obere der Elektroden liegt an einer hochfrequenten Wechselspannung. Auf der unteren Elektrode befinden sich die zu bearbeitenden, d. h. zu ätzenden oder zu beschichtenden Substrate. In der Mitte der unteren Elektrode befindet sich eine Öffnung, durch die das beim Verarbeiten benötigte Gas entweder in den Raum zwischen den Elektroden eingeleitet, oder aus diesem Raum abgesaugt wird. Diese Anordnung stellt sicher, daß während der Ätz — oder Beschichtungsoperation über die Substrate ein kontinuierlicher Gasstrom entweder vom Rand des Elektrodenraums zur Öffnung in der unteren Elektrode oder in umgekehrter Richtung strömt. Ein solcher Plasmareaktor läßt sich dazu verwenden, auf die untere Elektrode gelegte Substrate entweder mit einer Schicht aus einem Material, wie z. B. Siliciumnitrid zu bedecken oder zu ätzen, wobei das Ätzen entweder unter Verwendung einer Maske aus einem gegenüber den Ätzspezies resistenten Material selektiv oder so erfolgt, daß ganzflächig Material abgetragen wird. Während der genannten Operationen wird zwischen den Elektroden eine Glimmentladung aufrechterhalten, welche eine doppelte Wirkung hat. Einerseits werden die Substrate mit Gaspartikeln « bombardiert », welche aufgrund der zwischen den Elektroden vorhandenen elektrischen Feldern eine hohe kinetische Energie aufweisen und andererseits werden Gasatome bzw. -moleküle in der Glimmentladung ionisiert oder mindestens chemisch angeregt. Je nachdem, welches Material geätzt werden soll bzw. Mit welchem Material beschichtet werden soll, werden die zu verwendenden Gase ausgewählt. Beim Plasmaätzen bewirken die chemischen Reaktionen der Ätzspezies mit den zu ätzenden Substraten als auch die Bombardierung mit ionisierten Gasteilchen eine chemisch-physikalische Abtragung des zu ätzenden Materials und — in ungünstigen Fällen — auch eine Wiederabscheidung bereits entfernten Materials. Beim Beschichten gehen reaktive Gase, welche in die Reaktionskammer zugeführt werden, eine chemische Reaktion ein, welche durch die Glimmentladung im Elektrodenraum gefördert bzw. erst ermöglicht wird. Die Bombardierung der Substrate hat beim Beschichten den Effekt, daß einerseits die bei der chemischen Reaktion gebildeten Produkte schneller auf den Substraten abgeschieden werden, daß aber andererseits bereits abgeschiedenes Material wieder von den Substraten entfernt wird. Die Geschwindigkeit, mit der die Substrate abgeätzt werden bzw. mit der Material auf den Substraten abgeschieden wird, ergibt sich aus dem Zusammenwirken der obengenannten physikalischen und chemischen Effekte.

Bei dem erfindungsgemäßen Plasmareaktor weist die obere der beiden Elektroden in Bereichen, welche der Lage und Gestalt nach durch die auf der unteren Elektrode liegenden Substrate bestimmt sind, kein Elektrodenmaterial auf. Um zu verhindern, daß durch die genannte spezielle Ausbildung der oberen Elektrode der Gasfluß im Elektrodenraum beeinflußt wird, ist in den genannten Bereichen das Elektrodenmaterial durch ein dielektrisches Material ersetzt, so daß die obere Elektrode mindestens den Teil der unteren Elektrode abdeckt, auf dem sich Substrate befinden. Überraschenderweise wurde festgestellt, daß wenn der so ausgebildete Plasmareaktor unter sonst gleichen Bedingungen wie bei den bekannten Verfahren und Vorrichtungen benutzt wird, sowohl die Ätzgeschwindigkeit als auch die Geschwindigkeit, mit der die Substrate beschichtet werden, sich erhöhen. Befindet sich beispielsweise in der oberen Elektrode ein kreisrundes Loch im Elektrodenmaterial, so wächst auf einem direkt darunterliegenden Substrat in einem Bereich, welcher konzentrisch mit der Projektion des Lochs auf die untere Elektrode und auch kreisrund ist und bei einem Elektrodenabstand von ungefähr 2,5 cm einen Radius hat, welcher ungefähr doppelt so groß ist wie das Loch in der oberen Elektrode, ungefähr 30 %

3

mehr Siliciumnitrid auf als in Gebieten außerhalb dieses Bereichs. Wurde der so ausgebildete Plasmareaktor zum Ätzen von Siliciumnitrid eingesetzt, so wurde festgestellt, daß die erhöhte Ätzwirkung außer in dem genannten runden Bereich auch noch in einer allmählich schmäler werdenden Zone (« Kometenschweif »), welche sich vom Ort des Lochs in Richtung des Gasflusses erstreckt, vorhanden ist. Soll der Plasmareaktor zum Beschichten eingesetzt werden, so ist bei der bevorzugten Ausbildung der oberen Elektrode über jedem der üblicherweise kreisscheibenförmigen Substrate ein rundes Loch vorgesehen, dessen Mittelpunkt genau über dem Mittelpunkt des entsprechenden Substrats liegt, und dessen Durchmesser etwa halb so groß wie das Substrat ist. Da Material nicht nur auf der Oberfläche der Substrate, sondern genauso auf den Bereichen der unteren Elektrode zwischen den Substraten abgeschieden wird, ist die genannte Ausbildung der oberen Elektrode deshalb vorteilhaft, weil bei ihr die Bereiche, in welchen mit erhöhter Geschwindigkeit abgeschieden wird, in etwa mit den Substratoberflächen zusammenfallen, während in den Bereichen, in welchen an sich eine Materialabscheidung unerwünscht ist, die Abscheidung mit wesentlich geringerer Geschwindigkeit als im Bereich der Substrate erfolgt. Beim Ätzen liegen die Verhältnisse anders, weil nur die Substratoberflächen bzw. Gebiete auf den Substratoberflächen geätzt werden, während die Bereiche zwischen den Substraten gegenüber dem Ätzangriff resistent sind. Deshalb ist bei den zum Ätzen verwendeten Plasmareaktoren die Ausbildung der oberen Elektrode unkritisch, solange gewährleistet ist, daß die Bereiche ohne Elektrodenmaterial in der oberen Elektrode so lokalisiert und ausgebildet sind, daß die ganze Oberfläche jedes der Substrate den Bedingungen ausgesetzt ist, bei denen die Ätzung mit der erhöhten Geschwindigkeit erfolgt. Es ist zunächst überraschend, daß, worauf weiter oben schon hingewiesen wurde, ein — beispielsweise — kreisrundes Loch in der oberen Elektrode, je nachdem ob Material abgeschieden oder geätzt werden soll, auf unterschiedlich große und unterschiedlich ausgebildete Bereiche auf der unteren Elektrode Auswirkungen hat — beim Abscheiden ist der Bereich auch kreisrund, während beim Ätzen der Bereich eine Verlängerung nach Art eines « Kometenschweifs » hat. Offenbar ist dieser Unterschied darauf zurückzuführen, daß durch das Loch in der oberen Elektrode beim Abscheiden eine Beeinflussung des Aufwachsvorgangs unmittelbar an der zu beschichtenden Oberfläche erfolgt (Beeinflussung der Oberflächenreaktionen), während beim Ätzen die Konzentration der ätzaktiven Spezies im Raum zwischen den Elektroden beeinflußt wird (Beeinflussung der Gasphasenreaktionen). Da diese Spezies noch dem Einfluß des Gasstromes unterworfen sind, ist es verständlich, daß der Bereich mit der erhöhten Konzentration an ätzaktiven Spezies nicht nur den Raum unterhalb des Lochs und seine unmittelbare Umgebung umfaßt, sondern noch eine Erweiterung in der Flußrichtung des Gases aufweist.

Im folgenden sollen anhand der Figuren drei Ausführungsformen des erfindungsgemäßen Plasmareaktors beschrieben werden. Die Figuren zeigen nur diejenigen Teile des Plasmareaktors, welche für die Erfindung wesentlich sind, und zwar für jede der drei Ausführungsformen einen Querschnitt durch die Elektroden und den Elektrodenraum und die obere Elektrode in Aufsicht.

Die in den Fign. 1A und 1B gezeigte Ausführungsform ist zum Ätzen und zum Aufbringen von Schichten geeignet. Der Plasmareaktor weist zwei runde Elektroden 1 und 2 auf. Die Elektroden — das gilt für alle Ausführungsformen des erfindungsgemäßen Plasmareaktors — müssen nicht dieselbe Gestalt haben. Erforderlich ist, daß der ganze Bereich der unteren Elektrode 1, welcher mit Substraten 3 belegt ist, und möglichst auch die unten erwähnte Öffnung 5 durch entweder aus Elektrodenmaterial oder aus dielektrischem Material bestehenden Bereichen der Elektrode 2 abgedeckt sind. Dies ist notwendig für eine optimale Führung der Gase über die Substrate 3. Die obere Elektrode 2 liegt an einer hochfrequenten Wechselspannung. Auf der unteren Elektrode 1 liegen die Substrate 3, beispielsweise runde Halbleiterplättchen, welche bearbeitet werden sollen. Über den Substraten 3 befinden sich in der Elektrode 2 Löcher im Elektrodenmaterial 7, deren Mittelpunkte über dem Mittelpunkt jeweils eines Substrats liegt, deren Ausbildung in der Elektrodenebene geometrisch ähnlich der Ausbildung der Substrate ist, deren Abmessungen vom Rand zum Mittelpunkt jedoch bis zu 50 % kleiner sind als die entsprechenden Abmessungen der Substrate. Die Löcher im Elektrodenmaterial sind mit Quarzfenstern 4 ausgefüllt. Die Elektrode 1 weist in der Mitte eine Öffnung 5 auf, durch welche der Gasstrom 6 entweder in den Raum zwischen den Elektroden geleitet oder aus ihm abgepumpt wird. Die in der Fig. 1A gezeigte Elektrodenanordnung befindet sich in einer nicht gezeigten Reaktionskammer, welche mindestens eine Zuleitung für die benötigten Gase und eine mit einer nicht gezeigten Vakuumpumpe verbundene Absaugung aufweist. Um welchen Faktor die genannten Lochabmessungen kleiner sind als die Substratabmessung hängt ab vom Elektrodenabstand und von den Reaktionsbedingungen, auf welche weiter unten eingegangen wird, und muß durch Versuche bestimmt werden. Das Größenverhältnis Loch : Substrat, die geometrische Ähnlichkeit von Loch und Substrat und die Lage des Lochs zum Substrat ist jedoch — aus den oben angegebenen Gründen — nur kritisch, wenn der Plasmareaktor zum Aufbringen von Material eingesetzt wird. Wird mit dem Reaktor geätzt, so muß nur gewährleistet sein, daß das Substrat sich vollständig innerhalb eines Bereichs auf der unteren Elektrode befindet, in welchem das zugehörige Loch in der oberen Elektrode eine erhöhte Ätzgeschwindigkeit bewirkt. Das heißt mit anderen Worten, daß, wenn der Reaktor zum Ätzen eingesetzt wird, das Loch größer als oder gleich groß wie das Substrat sein kann, Loch und Substrat nicht notwendigerweise geometrisch ähnlich sein müssen und daß auch die Mittelpunkte von Loch und Substrat nicht genau übereinander liegen müssen.

Die Fign. 2A und 2B zeigen schematisch im Querschnitt bzw. in Aufsicht die Elektrodenanordnung einer weiteren Ausführungsform des erfindungsgemäßen Plasmareaktors. Die Anordnung weist zwei

4

runde Elektroden 1 und 2 auf, von denen die untere Elektrode 1 gleich wie die Elektrode 1 in der Fig. 1A ausgebildet ist. Die obere Elektrode 2 besteht aus einem Kreisring aus Elektrodenmaterial 7, dessen äußerer Durchmesser bevorzugt gleich dem äußeren Durchmesser der Elektrode 1 ist. Der Kreisring aus Elektrodenmaterial 7 umrahmt eine Kreisscheibe 4 aus einem dielektrischen Material, beispielsweise aus Quarz, auf welcher auf der Oberseite, d. h. auf der von dem Elektrodenraum abgewandten Seite, Leiterzüge 9 aufgebracht sind, welche beispielsweise — wie die Fig. 2B zeigt, eine Kreuzesform haben können, und welche dazu dienen, die elektrische Verbindung zwischen der Spannungsquelle und dem Ring aus Elektrodenmaterial herzustellen. Wenn erreicht werden soll, daß sich ein Plasma nur zwischen dem Ring aus Elektrodenmaterial und der Elektrode 1 und nicht auch zwischen den Leiterzügen 9 und der Elektrode 1 ausbildet, so ist es vorteilhaft, auf der Unterseite der Quarzplatte 4. d. h. auf ihrer dem Elektrodenraum zugewandten Seite eine vom Ring aus Elektrodenmaterial isolierte, in der Fig. 2A nicht gezeigte Metallabschirmung aufzubringen. Aus den schon oben diskutierten Gründen ist die in den Fign. 2A und 2B gezeigte Ausführungsform nur für das Plasmaätzen vorteilhaft einsetzbar. Die Fläche auf der unteren Elektrode 1, auf welche die Substrate 3 gelegt werden müssen, damit sie über ihre ganze Oberfläche der erhöhten Ätzwirkung ausgesetzt sind, wird durch den Kreisring aus Elektrodenmaterial 7 bestimmt, ist wie dieser kreisrund, und ihr äußerer Umfang ist größer als der innere Umfang des Kreisrings. Um wieviel größer der äußere Umfang der Fläche ist, hängt ab von dem Elektrodenabstand und von den Ätzbedingungen. Der Gasfluß bei der in der Fig. 2A und 2B gezeigten Ausführungsform kann nur in einer Richtung, und zwar vom äußeren Rand des Elektrodenraums zu der Öffnung 5 in der Mitte der Elektrode 1, von wo es abgesaugt wird, erfolgen.

In den Fign. 3A und B sind im Querschnitt bzw. in Aufsicht die Elektrodenanordnungen einer dritten Ausführungsform des erfindungsgemäßen Plasmareaktors gezeigt. In der gezeigten Anordnung liegen sich wie in den Fign. 1A und 2A zwei kreisrunde, plattenförmige Elektroden 1 und 2 in paralleler Anordnung gegenüber. Die obere Elektrode 2 besteht aus einer Kreisscheibe aus Elektrodenmaterial 7 und einem diese Kreisscheibe umrahmenden Kreisring 4 aus Quarz, dessen Umfang etwa gleich groß ist wie der äußere Umfang der Elektrode 1. Die Kreisscheibe liegt an einer hochfrequenten Wechselspannung. Aus den bereits oben diskutierten Gründen eignet sich die in den Fign. 3A und 3B gezeigten Ausführungsformen zum Ätzen, aber weniger zum Aufwachsen von Schichten. Der Bereich auf der unteren Elektrode 1, innerhalb dessen Substrate mit der erhöhten Geschwindigkeit geätzt werden, ist ein Kreisring, dessen innere Umrandung mit der Projektion der Kreisscheibe aus Elektrodenmaterial 7 auf die Elektrode 1 überlappt. Die Stärke der Überlappung hängt ab vom Elektrodenabstand und von den Ätzbedingungen. Bei der in den Fign. 3A und 3B gezeigten Ausführungsform strömt das Gas durch die Öffnung 5 in den Elektrodenraum ein und wird an dessen äußerem Rand abgesaugt.

Die mit dem erfindungsgemäßen Reaktor durchgeführten Ätz- und Abscheidungsverfahren verlaufen praktisch unter denselben Bedingungen, wie sie bei der Verwendung der bekannten Reaktoren angewandt werden. So wird auch bei Verwendung des erfindungsgemäßen Reaktors die Ätzgeschwindigkeit, mit welcher ein Substrat geätzt wird, bestimmt durch die Zusammensetzung der verwendeten Gasmischung, den Gasfluß und den Druck der Gase, die elektrische Leistung, die Temperatur der Substrate und die Oberflächenkinetik der am Ätzvorgang beteiligten Gasspezies, d. h. Phänomene wie Diffusion, Adsorption und Desorption. Für die Geschwindigkeit, mit welcher mittels der bekannten Plasmareaktoren Schichten aufgewachsen werden, spielen praktisch dieselben Parameter wie die beim Ätzen genannten die entscheidende Rolle. Bei Verwendung des erfindungsgemäßen Reaktors kommt jedoch als entscheidender zusätzlicher Parameter die Ausbildung der oberen Elektrode des Plasmareaktors und die auf die spezielle Ausbildung der oberen Elektrode abgestimmte Positionierung der Substrate auf der unteren Elektrode hinzu. Dies macht es erforderlich, daß bei Durchführung der Ätz- bzw. Abscheidungsverfahren mittels des erfindungsgemäßen Plasmareaktors, dessen obere Elektrode beispielsweise entsprechend einer der anhand der Fign. 1A bis 3B besprochenen Ausführungsformen ausgebildet sein kann, die Substrate so auf der unteren Elektrode positioniert werden, daß sie alle, und zwar mit ihrer ganzen Oberfläche innerhalb der Bereiche auf der unteren Elektrode liegen, in welchen die erhöhte Ätz- bzw. Aufwachsgeschwindigkeit gewährleistet ist.

Der erfindungsgemäße Plasmareaktor läßt sich generell einsetzen bei allen Plasmaätz- und Plasmaabscheidungsverfahren. Besonders vorteilhaft wird er eingesetzt beim Abscheiden und Ätzen von Siliciumnitrid, Siliciumdioxid und Polysilicium.

Im folgenden soll anhand je eines Beispiels das Ätzen von Substraten und das Aufwachsen von Schichten auf Substraten mittels des erfindungsgemäßen Plasmareaktors noch genauer erläutert werden.

Beispiel I

Im folgenden wird das Ätzen einer Siliciumnitridschicht, welche durch chemisches Niederschlagen aus der Gasphase auf einem Siliciumplättchen erzeugt worden ist, in einem aus $CF_4$ und $O_2$ erzeugten Plasma beschrieben. Verwendet wurde dabei ein Plasmareaktor, dessen obere Elektrode in etwa so ausgebildet war, wie es die Fign. 1A und 1B schematisch zeigen. Der Elektrodenabstand betrug 5,2 cm. Ein Teil, jedoch nicht alle der Substrate, lagen unter je einem Loch im Elektrodenmaterial der oberen Elektrode, wobei der Durchmesser der Substrate etwa doppelt so groß wie der Durchmesser der Löcher

5

war. Einige der Substrate lagen in Bereichen der unteren Elektrode, die nicht durch die Löcher in der oberen Elektrode beeinflußt werden, d. h. weder direkt unter dem Loch, noch im Bereich des zugehörigen « Kometenschweifs » liegen. Es wurde unter den folgenden Versuchsbedingungen gearbeitet :

| | |
|---|---|
| $CF_4$-Fluß = | 480 ml/min. *) |
| $O_2$-Fluß = | 33 ml/min. *) |
| Gasdruck = | 3,33 mbar |
| Leistung = | 300 Watt |
| Substrattemperatur = | 200 °C |
| Ätzzeit = | 90 Sekunden |

*) bei Standardbedingungen

Bei den unter den Löchern in der oberen Elektrode gelegenen Substraten wurde eine Ätzgeschwindigkeit von 0,59 nm/sec. und bei den nicht im Einflußbereich der Löcher liegenden Substrate eine Ätzgeschwindigkeit von 0,21 nm/sec. ermittelt. Das heißt, bei den unter den Löchern liegenden Substraten lag die Ätzgeschwindigkeit um den Faktor 2,81 höher als bei den nicht unter den Löchern liegenden Substraten. Die Gleichförmigkeit der Ätzung lagen bei den unter den Löchern liegenden Substraten, bezogen jeweils auf die gesamte Substratoberfläche, bei ± 3 %.

## Beispiel II

Im folgenden Beispiel wird das Aufwachsen einer Siliciumnitridschicht auf Siliciumsubstrate unter Verwendung eines Plasmareaktors, dessen obere Elektrode eine Ausbildung hatte, wie sie in etwa schematisch in den Fign. 1A und 1B gezeigt ist, wobei in einer $SiH_4$, $NH_3$ und Ar enthaltenden Atmosphäre ein Plasma erzeugt wurde. Einige jedoch nicht alle der Substrate lagen genau unter Löchern im Elektrodenmaterial der oberen Elektrode, deren Durchmesser ungefähr halb so groß wie der Durchmesser der Substrate war. Einige der Substrate lagen so auf der unteren Elektrode, daß sie mit ihrer gesamten Oberfläche außerhalb der Bereiche der unteren Elektrode lagen, welche direkt unter einem der Löcher in der oberen Elektrode lagen und von der Größe eines Substrats waren. Der Elektrodenabstand betrug 2,54 cm. Beim Abscheiden des Siliciumnitrids wurde unter den folgenden Bedingungen gearbeitet :

| | |
|---|---|
| $SiH_4$-Fluß (100 %iges $SiH_4$) = | 36 ml/min. *) |
| $NH_3$-Fluß **) = | 360 ml/min. *) |
| Ar-Fluß = | 570 ml/min. *) |
| Gasdruck = | 1,1 mbar |
| Substrattemperatur = | 200 °C |
| Leistung = | 200 Watt |
| Abscheidungsdauer = | 10 Minuten |

*) bei Standardbedingungen
**) Ar-$NH_3$-Gemisch mit 10 Volum-% $NH_3$

Bei den unter den Löchern in der oberen Elektrode liegenden Substraten wurde eine Abscheidungsgeschwindigkeit von 0,14 nm/sec. und bei den nicht unter den Löchern liegenden Substraten eine Abscheidungsgeschwindigkeit von 0,12 nm/sec. festgestellt, d. h. die Abscheidungsgeschwindigkeit unter den Löchern war um den Faktor 1,17 größer als außerhalb der durch die Löcher beeinflußten Elektrodenbereiche. Trotz der unterschiedlichen Aufwachsgeschwindigkeit wurde überraschenderweise bei allen aufgewachsenen Schichten derselbe Brechungsindex (1,88) und dieselbe Ätzgeschwindigkeit gemessen.

**Patentansprüche**

1. Plasmareaktor zum Ätzen und Beschichten von Substraten (3) mittels in einer Gasentladung angeregter Gaspartikel, welcher in einer Reaktionskammer zwei zueinander parallele, übereinander angeordnete, plattenförmige Elektroden (1, 2) aufweist, wobei die obere Elektrode (2) an einer hochfrequenten Wechselspannung liegt und auf der unteren Elektrode (1) die Substrate liegen, und diese Elektrode außerdem in der Mitte eine Öffnung hat, durch welche das reaktive Gas in den Elektrodenraum geleitet oder aus diesem abgesaugt wird, dadurch gekennzeichnet, daß die obere Elektrode (2) in Bereichen (4) kein Elektrodenmaterial (7) aufweist, welche der Lage und der Gestalt nach durch die auf der unteren Elektrode (1) liegenden Substrate (3) bestimmt sind und mindestens über den Substraten (3) eine selektive Schwächung des elektrischen Feldes im Elektrodenraum bewirken.

2. Plasmareaktor nach Anspruch 1, dadurch gekennzeichnet, daß in den genannten Bereichen (4) das Elektrodenmaterial (7) durch ein dielektrisches Material ersetzt ist, so daß die obere Elektrode (2) mindestens den Teil der unteren Elektrode (1) abdeckt, auf dem sich Substrate (3) befinden.

3. Plasmareaktor nach Anspruch 1 oder 2, dadurch gekennzeichnet, daß die Elektroden (1, 2) rund sind.

4. Plasmareaktor nach einem der Ansprüche 1 bis 3, dadurch gekennzeichnet, daß die obere Elektrode (2) Löcher im Elektrodenmaterial aufweist, welche eine geometrisch ähnliche Gestalt wie die darunter liegenden Substrate (3) haben, und deren Mittelpunkt über den Mittelpunkten der Substrate (3) liegen.

5. Plasmareaktor nach einem der Ansprüche 1 bis 3, dadurch gekennzeichnet, daß die obere Elektrode (2) Elektrodenmaterial (7) nur in einem um den Mittelpunkt der oberen Elektrode (2) angeordneten Gebiet aufweist, daß das Gas von der Mitte der unteren Elektrode (1) nach außen strömt und daß die Substrate (3) so auf der unteren Elektrode (1) angeordnet sind, daß sie mit der Projektion des genannten Gebiets auf die untere Elektrode (1) höchstens mit einem kleinen Teil ihrer Oberfläche überlappen.

6. Plasmareaktor nach einem der Ansprüche 1 bis 3, dadurch gekennzeichnet, daß die obere Elektrode (2) Elektrodenmaterial (7) nur in einem an den äußeren Elektrodenrand angrenzenden, in sich geschlossenen Gebiet aufweist, daß das Gas durch den Elektrodenraum zur Öffnung (5) in der unteren Elektrode (1) fließt und daß die Substrate (3) so auf der unteren Elektrode (1) angeordnet sind, daß sie mit der Projektion des genannten in sich geschlossenen Gebiets auf die untere Elektrode höchstens mit einem kleinen Teil ihrer Oberfläche überlappen.

7. Verfahren zum Plasmaätzen oder Beschichten von Substraten, dadurch gekennzeichnet, daß dabei ein Plasmareaktor gemäß einem der Patentansprüche 1 bis 6. verwendet wird.

8. Verfahren nach Anspruch 7, dadurch gekennzeichnet, daß zum Aufbringen von Schichten ein Plasmareaktor gemäß dem Patentanspruch 4 verwendet wird.

9. Verfahren nach Anspruch 7 oder 8, dadurch gekennzeichnet, daß es zum Abscheiden von Silicium, Siliciumdioxid und Siliciumnitrid angewandt wird.

10. Verfahren nach Anspruch 7, dadurch gekennzeichnet, daß es zum Ätzen von Silicium oder Siliciumverbindungen angewandt wird.

11. Verfahren nach einem der Ansprüche 7 bis 9, dadurch gekennzeichnet, daß Siliciumnitrid bei einem Druck von 1,07 mbar einer Leistung von 200 Watt und unter Zuleitung von 36 ml 100 %igem $SiH_4$, 360 ml eines $Ar/NH_3$-Gemisches mit 10 Volum-% $NH_3$ und 570 ml Ar/min. bei einer Substrattemperatur von 200 °C abgeschieden wird.

12. Verfahren nach einem der Ansprüche 7 oder 10, dadurch gekennzeichnet daß das Siliciumnitrid bei einem Druck von 3,33 mbar einer Leistung von 300 Watt bei einer Substrattemperatur von 200 °C und unter Zuleitung von 480 ml $CF_4$ und von 33 ml $O_2$/min. geätzt wird.

## Claims

1. Plasma reactor for etching and coating substrates (3) by means of gas particles excited in a gas discharge, comprising two planar electrodes (1, 2) arranged parallel to and above each other, wherein the upper electrode (2) is connected to a high-frequency AC voltage and the substrates are arranged on the lower electrode (1), the latter electrode being additionally provided with a center opening through which the reactive gas is led into the electrode space or sucked therefrom, characterized in that the upper electrode (2) is without electrode material (7) in regions (4) whose position and shape is determined by the substrates (3) arranged on the lower electrode (1) and which cause the electric field in the electrode space to be selectively weakened at least above the substrates (3).

2. Plasma reactor according to claim 1, characterized in that in said regions (4) the electrode material (7) is replaced by a dielectric material such that the upper electrode (2) covers at least that part of the lower electrode (1) on which substrates (3) are arranged.

3. Plasma reactor according to claim 1 or 2, characterized in that the electrodes (1, 2) are circular.

4. Plasma reactor according to any one of the claims 1 to 3, characterized in that the upper electrode (2) has holes in the electrode material whose geometrical shape is similar to that of the underlying substrates (3) and whose centers are positioned above the centers of substrates (3).

5. Plasma reactor according to any one of the claims 1 to 3, characterized in that the upper electrode (2) is provided with electrode material (7) only in a region surrounding the center of the upper electrode (2), that the gas flows from the center of the lower electrode (1) to the outside, and that the substrates (3) are arranged on the lower electrode (1) such that only a small portion of their surface overlaps with the projection of said region on the lower electrode (1).

6. Plasma reactor according to any one of the claims 1 to 3, characterized in that the upper electrode (2) is provided with electrode material (7) only in an annular region adjacent to the outer electrode edge, that the gas flows through the electrode space to the opening (5) in the lower electrode (1), and that the substrates (3) are arranged on the lower electrode (1) such that only a small portion of their surface overlaps with the projection of said annular region on the lower electrode.

7. Method for plasma etching or coating substrates, characterized in that a plasma reactor according to any one of the claims 1 to 6 is used.

8. Method according to claim 7, characterized in that a plasma reactor according to patent claim 4 is used to deposit layers.

9. Method according to claim 7 or 8, characterized in that it is used to deposit silicon, silicon dioxide and silicon nitride.

10. Method according to claim 7, characterized in that it is used to etch silicon or silicon compounds.

11. Method according to any one of the claims 7 to 9, characterized in that silicon nitride is deposited at a pressure of 1.07 mbar, a power of 200 Watt and by applying 36 ml of 100 per cent $SiH_4$, 360 ml of an $Ar/NH_3$ mixture with 10 per cent by volume $NH_3$ and 570 ml Ar/min. at a substrate temperature of 200 ºC.

12. Method according to any one of the claims 7 or 10, characterized in that the silicon nitride is etched at a pressure of 3.33 mbar, a power of 300 Watt and a substrate temperature of 200 ºC, applying 480 ml $CF_4$ and 33 ml $O_2$/min.

**Revendications**

1. Réacteur à plasma pour graver et recouvrir des substrats (3) à l'aide de particules de gaz excitées au moyen d'une décharge dans le gaz, et qui comporte, dans une enceinte réactionnelle, des électrodes en forme de plaques (1, 2) superposées et parallèles entre elles, dans lequel l'électrode supérieure (2) est placée sous tension alternative haute fréquence et les substrats sont situés sur l'électrode inférieure (1), et cette électrode possède en outre en son centre une ouverture au moyen de laquelle le gaz réactionnel est dirigé dans l'espace entre les électrodes ou est attiré entre cet espace, caractérisé en ce que l'électrode supérieure (2) ne comporte aucun matériau d'électrode (7) dans les zones (4) qui sont déterminées, du point de vue de la position et de la forme, par les substrats (3) situés sur l'électrode inférieure (1), et créent, au moins au-dessus des substrats (3), un affaiblissement sélectif du champ électrique dans l'espace entre les électrodes.

2. Réacteur à plasma selon la revendication 1, caractérisé en ce que, dans lesdites zones (4), le matériau d'électrode (7) est remplacé par un matériau diélectrique de sorte que l'électrode supérieure (2) recouvre au moins une partie de l'électrode inférieure (1), sur laquelle sont situés les substrats (3).

3. Réacteur à plasma selon la revendication 1 ou 2, caractérisé en ce que les électrodes (1, 2) sont circulaires.

4. Réacteur à plasma selon l'une des revendications 1 à 3, caractérisé en ce que l'électrode supérieure (2) comporte des trous ménagés dans le matériau d'électrode, qui possèdent une configuration géométrique semblable à celle des substrats (3) situés au-dessous de l'électrode, dont les centres sont situés au-dessus des centres des substrats (3).

5. Réacteur à plasma selon l'une des revendications 1 à 3, caractérisé en ce que l'électrode supérieure (2) comporte un matériau d'électrode (7) uniquement dans une zone située autour du centre de l'électrode supérieure (2), que le gaz circule vers l'extérieur à partir du centre de l'électrode inférieure (1) et que les substrats (3) sont disposés sur l'électrode inférieure (1) de telle sorte qu'ils sont, au maximum par une faible partie de leur surface, en recouvrement avec la projection de ladite zone sur l'électrode inférieure (1).

6. Réacteur à plasma selon l'une des revendications 1 à 3, caractérisé en ce que l'électrode supérieure (2) comporte le matériau d'électrode (7) uniquement dans une zone refermée sur elle-même et jouxtant le bord extérieur de l'électrode, que le gaz circule à travers l'espace entre les électrodes en direction de l'ouverture (5) située dans l'électrode inférieure (1) et que les substrats (3) sont disposés sur l'électrode inférieure (1) de telle sorte qu'ils sont, au maximum avec une faible partie de leur surface, en recouvrement avec la projection de ladite vanne refermée sur elle-même sur l'électrode inférieure.

7. Procédé pour réaliser une corrosion plasmatique ou déposer un revêtement sur des substrats, caractérisé en ce qu'on utilise un réacteur à plasma selon l'une des revendications 1 à 6.

8. Procédé selon la revendication 7, caractérisé en ce que pour le dépôt de couches, on utilise un réacteur à plasma selon la revendication 4.

9. Procédé selon la revendication 7 ou 8, caractérisé en ce qu'on l'utilise pour réaliser le dépôt de silicium, de bioxyde de silicium et de nitrure de silicium.

10. Procédé selon la revendication 7, caractérisé en ce qu'on l'utilise pour graver le silicium ou des composés du silicium.

11. Procédé selon l'une des revendications 7 à 9, caractérisé en ce que le nitrure de silicium est déposé sous une pression de 1,07 mbar, avec une puissance de 200 watts et moyennant l'apport de 36 ml de $SiH_4$ à 100 %, de 360 ml d'un mélange de $Ar/NH_3$ avec 10 % en volume de $NH_3$ et 570 ml de Ar/mn pour une température du substrat de 200 ºC.

12. Procédé selon l'une des revendications 7 ou 10, caractérisé en ce que le nitrure de silicium est gravé sous une pression de 3,33 mbars, avec une puissance de 300 watts et pour une température du substrat de 200 ºC moyennant l'envoi de 480 ml de $CF_4$ et de 33 ml de $O_2$/mn.

FIG.1A

FIG.1B

FIG.2A

FIG.2B

FIG.3A

FIG.3B